# EUROPÄISCHE PATENTSCHRIFT

(11) **EP 0 480 904 B1**
(45) Veröffentlichungstag und Bekanntmachung des Hinweises auf die Patenterteilung: **06.04.1994**
(21) Anmeldenummer: 91890210.7
(22) Anmeldetag: 16.09.1991
(51) Int. Cl.: G01D 5/245, G01B 3/20

(54) **Inkrementales Längenmesssystem**
Incremental length measuring system
Système incrémentiel de mesure de longueur

(30) Priorität: 11.10.1990 AT 2044/90
(43) Veröffentlichungstag der Anmeldung: 15.04.1992
(73) Patentinhaber: RSF-Elektronik Gesellschaft m.b.H., A-5121 Tarsdorf 93 (AT)
(72) Erfinder: Rieder, Heinz, A-5110 Oberndorf (AT); Schwaiger, Max, A-5121 Ostermiething (AT)
(74) Vertreter: Hübscher, Heiner, Dipl.-Ing.

(56) Entgegenhaltungen:
- EP-A- 0 155 348
- EP-A- 0 286 820
- WO-A-88/05151
- DE-U- 8 634 637
- US-A- 3 982 106
- US-A- 4 013 944

## Beschreibung

Die Erfindung betrifft ein inkrementales Längenmeßsystem, mit einem eine Meßteilung aufweisenden Maßstab, einer Abtasteinheit mit Abtastelementen zur Erzeugung von Meßsignalen bei der Abtastung der Meßteilung und einer Auswertungseinheit für diese Meßsignale, wobei eine zur Meßteilung parallele Referenzspur mit mehreren je einem Bezugspunkt entsprechenden Referenzmarken, zugeordnete Abtastelemente in der Abtasteinheit und ein von einem in Zuordnung zu einer Referenzmarke in einem Schutzgehäuse für den Maßstab und die Abtasteinheit anbringbaren Dauermagneten betätigbarer, mit der Abtasteinheit verstellbarer Auswahlschalter vorgesehen sind, der eine Erzeugung bzw. Abgabe eines Referenzimpulses nur an wenigstens einer über den Dauermagneten ausgewählten Referenzmarke zuläßt.

Bei derartigen Längenmeßsystemen wird eine Auswahlmöglichkeit für Referenzmarken vorgesehen, um die Herstellung der Meßsysteme zu vereinfachen und möglichst ohne äußeren Eingriff in die Kapselung des Meßsystemes die Auswahl eines bestimmten,z. B. dem Maschinen-Nullpunkt einer Werkzeugmaschine entsprechenden Referenzpunktes zu ermöglichen und die Messungen damit auf den Maschinen-Nullpunkt beziehen zu können. Eine Auswahl von Referenzmarken ist auch in anderen Fällen sinnvoll, wenn auf sie bezogene Messungen durchzuführen sind. Aus der DE-A 18 14 785 sind mechanische Ein- Ausschalter bekannt, die bei der Verstellung der Abtasteinheit über Anschläge betätigt werden und die Auswertungsschaltung nur an vorgewählten Referenzmarken aktivieren. Längenmeßsysteme der eingangs genannten Art, bei denen an vorwählbaren Maßstabstellen anbringbare Dauermagnete zur Betätigung von als in der Abtasteinheit integrierten Reed-Relais Verwendung finden, sind aus der DE-B2 25 40 412 bekannt. Die Anbringung solcher Dauermagnete am Maßstab erfordert bei gekapselten Längenmeßsystemen einen unerwünschten Eingriff ins Innere des Schutzgehäuses. Ferner besteht bei der meist üblichen Klemmbefestigung des Dauermagneten am Maßstabkörper die Gefahr, daß dieser Dauermagnet bei längerer Betriebszeit verrutscht oder abfällt. Es wurde deshalb schon vorgeschlagen, im Schutzgehäuse eine von dem Maßstab und Abtasteinheit aufnehmenden Innenraum getrennte Längsbohrung vorzusehen, in die der Dauermagnet vom Gehäuseende her eingeschoben wird, wobei dieser Dauermagnet durch die Bohrung bis zu beiden Enden ausfüllende Distanzstücke in seiner Lage gesichert wird. Hier ergibt sich eine aufwendige Montage und das Maßstabgehäuse muß an den Enden für das Einfädeln bzw. Herausziehen des Dauermagneten und der Distanzstücke zugänglich sein.

Für genauere Messungen ist es erwünscht, daß bei unterschiedlichen Wärmedehnungen des Maßstabkörpers, des Schutzgehäuses und des Objektes, auf dem das Längenmeßsystem montiert ist, im Normalfall das Bett einer Werkzeugmaschine, keine merkbare Verstellung der ausgewählten Referenzmarke gegenüber dem Maschinen-Nullpunkt stattfindet. Es wurde versucht, den Maßstab nur im Bereich seiner Längsmitte unter Verwendung eines Klebers geringer Elastizität im Schutzgehäuse festzulegen, durch nachgiebige Befestigung der übrigen Maßstabteile aber eine Längsverstellung dieser Teile gegenüber dem Schutzgehäuse zuzulassen und auch das Schutzgehäuse durch eine Mittelbefestigung gegenüber dem Objekt festzulegen, wobei bisher für die Enden des Schutzgehäuses zwar starre Befestigungsstellen am Objekt, aber zwischen diesen Befestigungsblöcken und dem Ende des Schutzgehäuses linear verstellbare Elemente, z. b. besonders geformte Federn, Gelenkverbindungen mit einander kreuzenden Gelenkachsen u. dgl. vorgesehen werden. Diese Art der Montage ist aufwendig und erfüllt nur dann tatsächlich die gestellte Aufgabe, wenn die starre Befestigung des Maßstabgehäuses bzw. die Festlegung des Maßstabkörpers gegenüber dem Schutzgehäuse tatsächlich zufällig am Maschinen-Nullpunkt erfolgt.

Hauptaufgabe der Erfindung ist die Schaffung eines Längenmeßsystems der eingangs genannten Art, bei dem eine Auswahl beliebiger Referenzmarken mit einfachen Mitteln und ohne Eingriff in den Innenraum des Schutzgehäuses ermöglicht wird und die getroffene Auswahl im Bedarfsfall geändert werden kann. Eine Teilaufgabe der Erfindung besteht in der Schaffung eines Längenmeßsystems, bei dem Längsverschiebungen des Maßstabkörpers im Bereich der ausgewählten Referenzmarke auch dann verhindert werden, wenn die ausgewählte Referenzmarke sich nicht genau in der Maßstablängsmitte befindet.

Die gestellte Hauptaufgabe wird dadurch gelöst, daß bei einem inkrementalen Längenmeßsystem der eingangs genannten Art jeder auswählbaren Referenzmarke im Schutzgehäuse ein Dauermagnet fest zugeordnet und über Stelltriebe aus einer bezüglich des Auswahlschalters inaktiven in eine aktive Stellung verstellbar ist.

Für die Verstellung der Dauermagnete aus der aktiven in die inaktive und umgekehrt, können einfache Einrichtungen Verwendung finden. Da ohnehin jeder auswählbaren Referenzmarke ein Dauermagnet zugeordnet ist, sind keine Umbauten oder längeren Montagearbeiten am Längenmeßsystem erforderlich.

Nach einer bevorzugten Ausführung ist jeder Dauermagnet mit einem im Gehäuse verdreh- oder schwenkbaren Träger aus einer vom Bewegungspfad des Auswahlschalters abweisenden Stellung in eine den Schalter bei dessen Vorbeibewegung aktivierende Stellung verstellbar angebracht.

Nach einer Weiterbildung ist der Auswahlschalter in einem äußeren Mitnehmer für die Abtasteinheit und die Dauermagnete sind mit ihren Trägern in einer neben diesem Mitnehmer im Schutzgehäuse in Längsrichtung vorgesehenen Aufnahmebohrung oder -nut angebracht und von der Gehäuseaußenseite her verstellbar. Diese Ausführung hat den Vorteil, daß Abtasteinheit und Maßstab für Längenmeßsysteme ohne Referenzpunktauswahl gleich aufgebaut werden können, wobei, wenn das Schutzgehäuse entsprechende Aufnahmeeinrichtungen für die Dauermagnete und der Mitnehmer Aufnahmeeinrichtungen für den Schalter enthält, auch eine nachträgliche Ausstattung des Meßsystems mit Auswahleinrichtungen möglich ist.

Nach einer anderen Ausführungsmöglichkeit sind bei an der Abtasteinheit innerhalb der Rohröffnung des Schutzgehäuses angebrachtem Auswahlschalter die Dauermagnete an über äußere Stelltriebe verstellbaren Trägern im Schutzgehäuse untergebracht. Dabei können diese Dauermagnete an mit Fußteilen in Längsnuten des meist aus einem Aluminiumstrangpreßprofil gebildeten Gehäuses schwenkbar gelagerten, durch verschließbare Gehäuseöffnungen hindurch verschwenkbaren und in den Schwenkendstellungen feststellbaren Klappen sitzen.

Eine Ausführungsvariante, die einen einfachen Aufbau und eine leichte Montierbarkeit der Dauermagnete ermöglicht, ist dadurch gekennzeichnet, daß als Träger für die Dauermagnete ein wenigstens über die Länge des Anbringungsbereiches der auswählbaren Referenzmarken am Maßstab vorzugsweise aber über die gesamte Maßstablänge durchgehendes Profilband aus elastisch, insbesondere gummielastisch verformbaren Material vorgesehen ist, das mit einem Fußteil an einem Rand im Klemmsitz in eine Haltenut im Inneren des rohrförmigen Schutzgehäuses eingreift und die den einzelnen Referenzmarken zugeordneten Dauermagnete im Abstand vom Fußteil außerhalb des Aktivierungsbereiches für den Schalter trägt, wobei im Bereich jeder Referenzmarke eine verschließbare Gehäuseöffnung vorgesehen ist, über die das Band durch eingeführte Schrauben oder Einpreßkörper in diesem Bereich um den Fußteil abbiegbar ist, so daß sich der zugeordnete Dauermagnet in den Aktivierungsbereich für den Schalter verstellt. Man kann auch ein an beiden Rändern in Nuten des Schutzgehäuses festgehaltenes elastisch verformbares Band verwenden, das bezüglich des Gehäuseinnenraumes in der inaktiven Stellung konkav gewölbt ist und im Bereich eines aktivierten Magneten durch das Hineindrücken mittels der Schraube bzw. des Einpreßkörpers eine Konkavwölbung einnimmt. Durch ein derartig angebrachtes Band wird das Gehäuse gegen die Gehäuseöffnungen für die Schrauben bzw. Einpreßkörper zusätzlich abgedichtet.

Zur Lösung der erwähnten Teilaufgabe ist vorgesehen, daß die Stelltriebe und/oder Träger für die Dauermagnete in ihrer den Dauermagnet in der Aktivierungsstellung haltenden Lage zugleich den im Gehäuse in einer Nut zum Ausgleich unterschiedlicher Wärmedehnungen des Gehäuses, Maßstabes bzw. des mit dem Längenmeßsystem ausgestatteten Objektes im erforderlichen Maß über nachgiebige Halterungen längsverstellbar gehaltenen Maßstabkörper im Bereich der ausgewählten Referenzmarke festlegen, insbesondere festklemmen. Dabei ist vorzugsweise das einen Träger bildende Schutzgehäuse im Bereich der ausgewählten Referenzmarke mit einem oder mehreren Halteelementen in Längsrichtung unbeweglich am Objekt befestigbar, so daß die ausgewählte Referenzmarke mit dem Festpunkt des Schutzgehäuses und damit im Normalfall auch mit dem Maschinen-Nullpunkt zusammenfällt. Damit hier bei einfach bleibendem Gesamtaufbau des Gehäuses und der Montageelemente unterschiedliche Wärmedehnungen keinen störenden Einfluß haben können, ist vorgesehen, daß zusätzlich zu der unbeweglichen Halterung im Bereich der ausgewählten Referenzmarke in Längsrichtung nachgiebige Halterungen für das Schutzgehäuse in Form von mit Abstand von den Längsenden dieses Schutzgehäuses angebrachten Halteelementen vorgesehen sind, die mit Fußteilen durch Gehäuseschlitze hindurch in die im Mittelbereich des Gehäuses zur Halterung der Magnetträger dienenden Gehäuselängsnuten oder -bohrungen längsverschiebbar eingreifen. Die beschriebene Gesamtkonstruktion kann nach einer Variante auch dann eingesetzt werden, wenn keine Dauermagneten zur Auswahl einer Referenzmarke verwendet werden. Hier werden diese Dauermagnete durch gleiche Stellkörper ersetzt, mit deren Hilfe der Maßstab festgeklemmt werden kann. Im Normalfall sind im Endbereich des Maßstabkörpers keine auswählbaren Referenzmarken vorhanden, so daß hier Platz für die Anbringung der Fußteile der Halteelemente freibleibt.

Weitere Einzelheiten und Vorteile des Erfindungsgegenstandes entnimmt man der nachfolgenden Zeichnungsbeschreibung.

In der Zeichnung ist der Erfindungsgegenstand beispielsweise veranschaulicht. Es zeigen
- Fig. 1: in stark schematisierter Darstellungsweise Maßstab, Schutzgehäuse, Abtasteinheit und Mitnehmer eines Längenmeßsystems bei im Schnitt dargestelltem Gehäuse,
- Fig. 2 und 3: vereinfachte Querschnittsdarstellungen zu Fig. 1 im Bereich eines in einer aktiven bzw. inaktiven Stellung befindlichem Dauermagneten,
- Fig. 4 und 5: zwei Querschnittsdarstellungen durch ein etwas abgewandeltes Meßsystem mit im Gehäuseinnenraum angebrachten Dauermagneten in der aktiven bzw. inaktiven Stellung,
- Fig. 6: eine weitere Querschnittsdarstellung durch ein neuerlich abgewandeltes Meßsystem im Bereich eines inaktiven Dauermagneten,
- Fig. 7: einen Querschnitt durch das Meßsystem nach Fig. 6 im Bereich eines mit Abstand vom Längsende angebrachten Halteelementes und
- Fig. 8: das Meßsystem nach den Fig. 6 und 7 schematisiert in Ansicht.

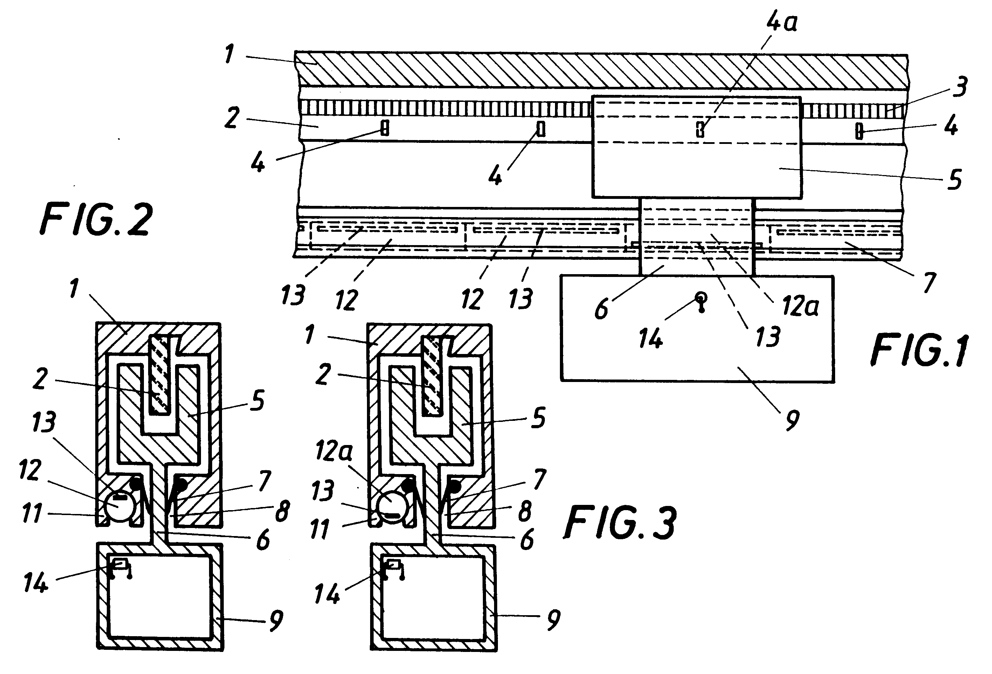

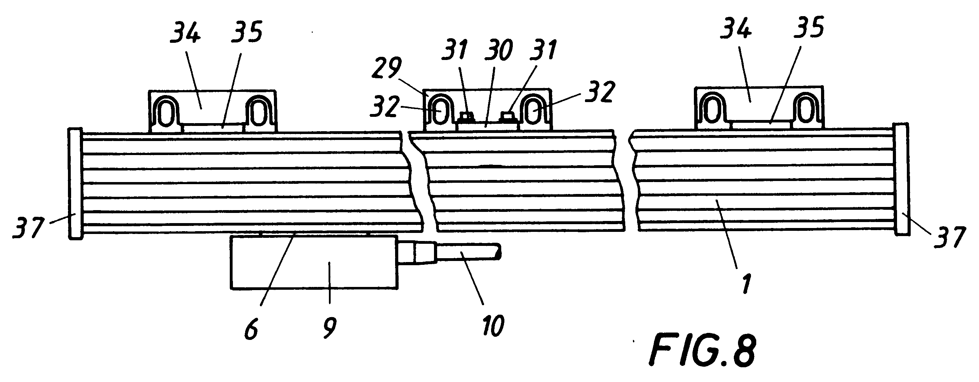

Nach den Fig. 1 bis 3 ist in einem zugleich einen Träger bildenden, rohrförmigen Schutzgehäuse 1 ein Maßstab 2 mit einer Meßteilung 3 und abstandsweise angebrachten Referenzmarken 4 untergebracht. Entlang des Maßstabes 2 ist eine Abtasteinheit 5 verstellbar, die nur in ihren Umrissen veranschaulicht wurde und an sich bekannte Beleuchtungs- und Empfangseinrichtungen zur optoelektronischen Abtastung der Meßteilung 3 und der Referenzmarken 4 aufweist, mit deren Hilfe durch Abtastung der Meßteilung 3 in Zählsignale umwandelbare Meßsignale und durch Abtastung der Referenzmarken 4 Referenzimpulse erzeugt werden können. Die Abtasteinheit 5 sitzt an einem schwertartigen Trägen 6 und ist mit diesem zwischen Dichtlippen 7 durch eine schlitzförmige Gehäuseöffnung 8 nach außen geführt, wo sie mit einem Mitnehmer 9 gekuppelt ist, von dem ein auch in Fig. 8 ersichtliches Kabel 10 zu einer Auswerte- bzw. Anzeigeeinheit zur Darstellung des Meßergebnisses führt. Soweit bisher beschrieben, ist das Längenmeßsystem prinzipiell bekannt.

In einer nach unten offenen einen hinterschnittenen Kreisquerschnitt aufweisenden Nut in einem Gehäuseschenkel 11 neben dem Schlitz 8 sind mit ihren Enden aneinander- stoßende Träger 12 untergebracht, die mit Hilfe nicht dargestellter Werkzeuge, z. B. mit Hilfe von in Radialbohrungen einführbarer nadelartiger Werkzeuge aus der in Fig. 2 und in Fig. 1 links und rechts der Abtasteinheit dargestellten Lage in die in Fig. 1 im Bereich der Abtasteinheit 5 und in Fig. 3 dargestellte aktivierungslage verstellt werden können. Jeder Träger 12 bzw. 12a ist mit einem Dauermagnet 13 ausgerüstet, der nur in seiner Aktivierungsstellung in der Lage ist, ein im Mitnehmer 9 angebrachtes Relais oder einen sonstigen Schalter 14 zu aktivieren. Jeder Träger 12 ist einer Referenzmarke 4 zugeordnet, so daß im Meßsystem nur bei aktiviertem Schalter 14 ein an der zugeordneten Referenzmarke 4a bei der Abtastung erzeugter Referenzimpuls ausgenützt wird.

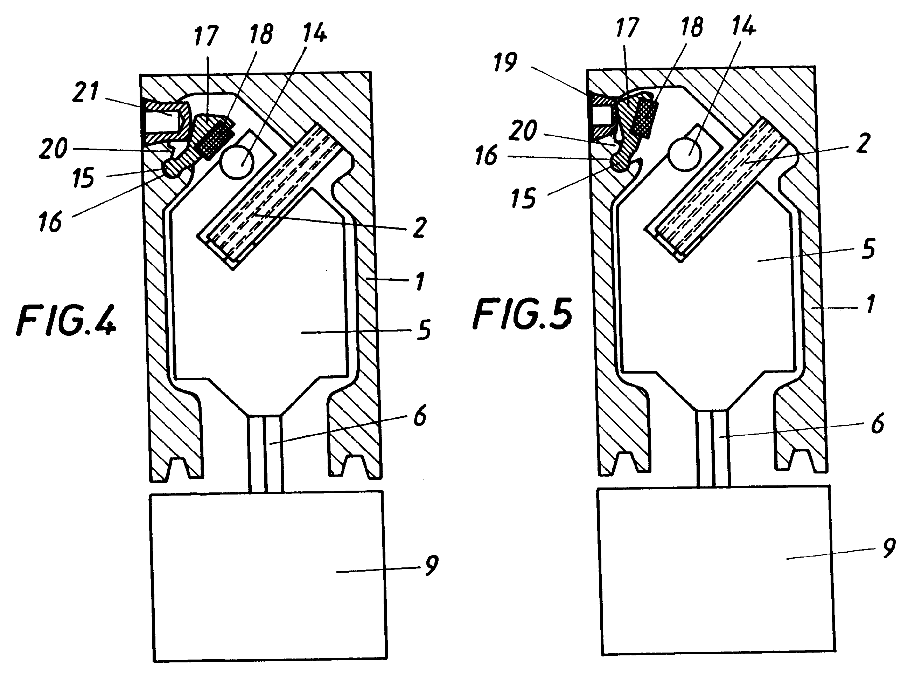

In den Fig. 4 und 5 wurde gleichwertige Teile mit den gleichen Bezugszeichen wie in den Fig. 1 bis 3 bezeichnet. Im Gegensatz zu den Fig. 1 bis 3 ist der Aktivierungsschalter 14 als Teil der Abtasteinheit 5 ausgebildet. Jeder Referenzmarke am Maßstabkörper 2 ist ein mit einem Fußteil 15 in einer eingeformten Gehäusenut 16 gehaltener klappenartiger Träger 17 zugeordnet, der einen Dauermagneten 18 trägt. Im Gehäuse ist jeder auswählbaren Referenzmarke und damit jeder Klappe 17 eine durch einen Stopfen 19 verschließbare Öffnung zugeordnet. Nach Herausnahme des Stopfens 19 wird die Klappe 17 mit Hilfe eines geeigneten Werkzeuges aus der Stellung nach Fig. 5 in die Stellung nach Fig. 4 verstellt, wobei auch durch bleibende Verformung des Randes 20 der erwähnten Öffnung eine Lagesicherung der Klappe 17 in der in Fig. 4 gezeigten Stellung vorgenommen werden kann. Ferner wird die Klappe durch einen größeren Stopfen 21 gesichert. Ein in der Stellung nach Fig. 4 befindlicher Dauermagnet 18 aktiviert bei der Vorbeibewegung der Abtasteinheit 5 den Schalter 14 im Sinne einer Auswertung des an der zugeordneten Referenzmarke erzeugten Referenzimpulses.

In Abänderung der Konstruktion nach den Fig. 4 und 5 besteht auch die Möglichkeit, an Stelle einzelner, klappeartiger Träger 17 ein über den Bereich der auswählbaren Referenzmarken durchlaufendes eine gleiche Profilform aufweisendes Band vorzusehen, an dem den Referenzmarken zugeordnet die Dauermagnete 18 befestigt sind. Bei dieser Ausführung wird ein ausgewählter Dauermagnet unter Biegung des Bandes nach innen mittels des Stopfens 21 verstellt.

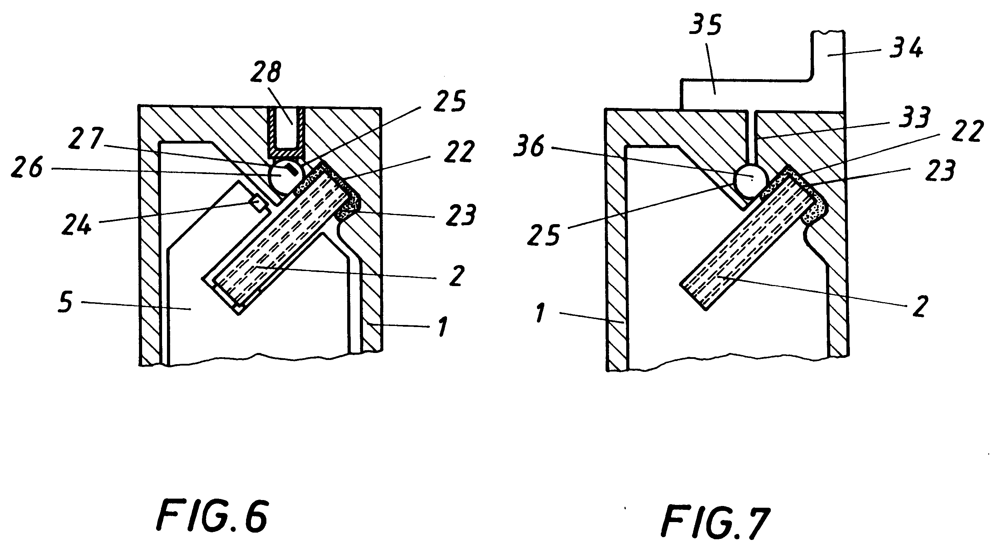

Bei der Ausführung nach den Fig. 6 bis 8 ist der Maßstabkörper 2 mit seinem Längsrand in einer Nut 22 des Schutzgehäuses 1 begrenzt längsverschiebbar befestigt, zu welchem Zweck eine elastisch nachgiebige die Nut 22 um den Rand des Maßstabkörpers 2 ausfüllende Halterung 23 vorgesehen ist. Diese Halterung kann aus einem Elastomer, z. B. Silikongummi, bestehen. Es ist aber auch möglich, quer zur Längsrichtung bzw. schräg dazu gewellte Federkörper einzusetzen.

Die Abtasteinheit 5 ist wieder mit einem Auswahlschalter 24 versehen. Jeder auswählbaren Referenzmarke wird in einer im Querschnitt einen kreissegmentförmigen Querschnitt aufweisenden, zur Nut 22 hin offenen Nut 25 ein in seiner Grundform zylindrischer, einseitig abgefaster Trägerkörper 26 mit Dauermagnet 27 zugeordnet, der in Fig. 6 in seiner inaktiven Stellung veranschaulicht ist. In der Decke des Gehäuses sind durch Stopfen 28 verschließbare Öffnungen vorgesehen, über die der Körper 26 so wie die Körper 12 nach den Fig. 2 und 3 verdreht werden kann, so daß der Dauermagnet 27 in einen Aktivierungsbereich für den Schalter 24 gelangt. Bei der Verdrehung verstellt sich der ursprünglich mit seiner Abfasung mit der Nutwandung fluchtende Körper 26 von der Seite her in die Nut 22 hinein und klemmt dadurch wegen der Verengung der Nut 22 unter Zusammendrückung des Elementes 23 den Maßstabkörper 2 im Bereich der ausgewählten Referenzmarke am Gehäuse 1 fest. Die durch die Stopfen 28 verschließbaren Öffnungen können als Gewindeöffnungen ausgebildet werden, so daß im Bereich der ausgewählten Referenzmarke ein Halteelement 29 für das Maßstabgehäuse 1 mit Hilfe von seinen Fußteil 30 durchsetzenden und in die von den Stopfen 28 freigegebenen Öffnungen eingreifenden Schrauben 31 befestigt werden kann. Durch Langlöcher 32 des Elementes 29 können Befestigungsschrauben zur Festlegung des Meßsystems an einer Maschine angebracht werden.

Außerhalb des Anbringungsbereiches der auswählbaren Referenzmarken sind gegen die Maßstabenden zu die im Mittelbereich Gewindeöffnungen bildenden Öffnungen durch einen Längsschlitz 33 verbunden. Hier vorgesehene Halteelemente 34 für das Gehäuse 1 tragen an ihrem unteren Flansch 35 Fußteile 36, die in ihrer Form dem zusammenhängenden Querschnitt von Schlitz 33 und Nut 25 angepaßt sind, so daß sie längsverschiebbar geführt werden und im erforderlichen Maß eine Längsverstellung des Gehäuses gegenüber den Befestigungsstellen dieser Befestigungselemente 34 am Objekt zulassen. Die Enden des Gehäuses 1 können durch Deckel 37 verschlossen sein.

## Patentansprüche

1. Inkrementales Längenmeßsystem, mit einem eine Meßteilung (3) aufweisenden Maßstab (2), einer Abtasteinheit (5) mit Abtastelementen zur Erzeugung von Meßsignalen bei der Abtastung der Meßteilung (3) und einer Auswertungseinheit für diese Meßsignale, wobei eine zur Meßteilung (3) parallele Referenzspur mit mehreren je einem Bezugspunkt entsprechenden Referenzmarken (4,4a), zugeordnete Abtastelemente in der Abtasteinheit (5) und ein von einem in Zuordnung zu einer Referenzmarke (4,4a) in einem Schutzgehäuse (1) für den Maßstab (2) und die Abtasteinheit (5) anbringbaren Dauermagneten (13,18,27) betätigbarer, mit der Abtasteinheit (5) verstellbarer Auswahlschalter (14,24) vorgesehen sind, der eine Erzeugung oder Abgabe eines Referenzimpulses nur an wenigstens einer über den Dauermagneten (13,18,27) ausgewählten Referenzmarke (4,4a) zuläßt, dadurch gekennzeichnet, daß jeder auswählbaren Referenzmarke (4, 4a) im Schutzgehäuse (1) ein Dauermagnet (13, 18, 27) fest zugeordnet und über Stelltriebe aus einer bezüglich des Auswahlschalters (14, 24) inaktiven in eine aktive Stellung verstellbar ist.

2. Längenmeßsystem nach Anspruch 1, dadurch gekennzeichnet, daß jeder Dauermagnet (13, 18, 27) mit einem im Schutzgehäuse (1) verdreh- oder schwenkbaren Träger (12, 17, 26) aus einer vom Bewegungspfad des Auswahlschalters (14, 24) abweisenden Stellung in eine den Auswahlschalter bei dessen Vorbeibewegung aktivierende Stellung verstellbar angebracht ist.

3. Längenmeßsystem nach den Ansprüchen 1 und 2, dadurch gekennzeichnet, daß der Auswahlschalter (14, 24) in einem äußeren Mitnehmer (9) für die Abtasteinheit (5) und die Dauermagnete (13) mit ihren Trägern (12, 12a) in einer neben diesem Mitnehmer im Schutzgehäuse (1) in Längsrichtung vorgesehenen Aufnahmebohrung oder -nut angebracht und von der Gehäuseaußenseite her verstellbar sind.

4. Längenmeßsystem nach den Ansprüchen 1 und 2, dadurch gekennzeichnet, daß bei an der Abtasteinheit (5) innerhalb einer Rohröffnung des Schutzgehäuses (1) angebrachtem Auswahlschalter (14, 24) die Dauermagnete (18, 27) an über äußere Stelltriebe verstellbaren Trägern (17, 26) im Schutzgehäuse (1) untergebracht sind.

5. Längenmeßsystem nach Anspruch 4, dadurch gekennzeichnet, daß die Dauermagnete (18) an mit Fußteilen (15) in Längsnuten (16) des Schutzgehäuses (1) schwenkbar gelagerten, durch verschließbare Gehäuseöffnungen hindurch verschwenkbaren und in den Schwenkendstellungen feststellbaren Klappen (17) sitzen.

6. Längenmeßsystem nach Anspruch 4, dadurch gekennzeichnet, daß als Träger für die Dauermagnete (18,27) ein wenigstens über die Länge des Anbringungsbereiches der auswählbaren Referenzmarken (4,4a) am Maßstab (2), vorzugsweise aber über die gesamte Maßstablänge durchgehendes Profilband aus elastisch, insbesondere gummielastisch verformbaren Material vorgesehen ist, das mit einem Fußteil an einem Rand im Klemmsitz in eine Haltenut im Inneren des rohrförmigen Schutzgehäuses (1) eingreift und die den einzelnen Referenzmarken (4,4a) zugeordneten Dauermagnete (18,27) im Abstand vom Fußteil außerhalb des Aktivierungsbereiches für den Auswahlschalter (14,24) trägt, wobei im Bereich jeder Referenzmarke (4,4a) eine verschließbare Gehäuseöffnung vorgesehen ist, über die das Band durch eingeführte Schrauben oder Einpreßkörper (19,21) in diesem Bereich um den Fußteil abbiegbar ist, so daß sich der zugeordnete Dauermagnet (18,27) in den Aktivierungsbereich für den Auswahlschalter (14,24) verstellt.

7. Längenmeßsystem nach einem der Ansprüche 1 bis 6, dadurch gekennzeichnet, daß die Stelltriebe und/oder Träger (26) für die Dauermagnete (27) in ihrer den Dauermagnet in der Aktivierungsstellung haltenden Lage zugleich den im Schutzgehäuse (1) in einer Nut (22) zum Ausgleich unterschiedlicher Wärmedehnungen des Schutzgehäuses (1), Maßstabes (2) bzw. des mit dem Längenmeßsystem ausgestatteten Objektes im erforderlichen Maß über nachgiebige Halterungen (23) längsverstellbar gehaltenen Maßstabkörper (2) im Bereich der ausgewählten Referenzmarke (4,4a) festlegen, insbesondere festklemmen.

8. Längenmeßsystem nach Anspruch 7, dadurch gekennzeichnet, daß das einen Träger bildende Schutzgehäuse (1) im Bereich der ausgewählten Referenzmarke (4,4a) mit Halteelementen (29) in Längsrichtung unbeweglich am Objekt befestigbar ist.

9. Längenmeßsystem nach den Anspruch 8, dadurch gekennzeichnet, daß zusätzlich zu der unbeweglichen Halterung (26, 29) im Bereich der ausgewählten Referenzmarke (4,4a) in Längsrichtung nachgiebige Halterungen (34) für das Schutzgehäuse (1) in Form von mit Abstand von den Längsenden dieses Schutzgehäuses angebrachten Halteelementen (34) vorgesehen sind, die mit Fußteilen (36) durch Gehäuseschlitze (33) hindurch in die im Mittelbereich des Gehäuses zur Halterung der Magnetträger dienenden Gehäuselängsnuten (25) oder -bohrungen längsverschiebbar eingreifen.

## Claims

1. An incremental length-measuring system comprising a scale (2) bearing measuring divisions (3), a scanning unit (5) with scanning elements for generating measuring signals when scanning the measuring divisions (3) and a unit for evaluating the measuring signals, a reference track parallel to the divisions (3) having a number of reference marks (4, 4a) corresponding to each reference point, associated scanning elements in the scanning unit (5) and a selector switch (14, 24) adjustable by the scanning unit (15) and actuatable by a permanent magnet (13, 18, 27) for disposing in accordance with a reference mark (4, 4a) in a protective casing (1) for the scale (2) and the scanning unit (5) being provided, the switch permitting a reference pulse to be generated or delivered only at at least one reference mark (4, 4a) selected via the permanent magnet (13, 18, 27), characterised in that a permanent magnet (13, 18, 27) is permanently associated with each selectable reference mark (4, 4a) in the casing (1) and is adjustable by adjusting drives from an inactive position relative to the switch (14, 24) to an active position.

2. A length-measuring system according to claim 1, characterised in that each permanent magnet (13, 18, 27) has a holder (12, 17, 26) pivotable or rotatable in the casing (1) for pivoting it from a position pointing away from the path of motion of the switch (14, 24) into a position for actuating the switch during its passage.

3. A length-measuring system according to claims 1 and 2, characterised in that the switch (14, 24) is disposed in an outer cam (9) for the scanning unit (5) and the permanent magnets (13) and holders (12, 12a) are disposed in a receiving bore or groove provided in the longitudinal direction adjacent the cam in the casing (1) and are adjustable from the outside of the casing.

4. A length-measuring system according to claims 1 and 2, characterised in that when the selector switch (14, 24) is disposed on the scanning unit (5) inside a tubular opening in the casing (1), the permanent magnets (18, 27) are disposed in the protective casing (1) on holders (17, 26) adjustable by external drives.

5. A length-measuring system according to claim 4, characterised in that the permanent magnets (18) rest on valves (17) having foot parts (15) pivotably mounted in longitudinal grooves (16) in the casing (1) and pivotable through closable openings in the casing and lockable in the pivoted end positions.

6. A length-measuring system according to claim 4, characterised in that the holder for the permanent magnets (18, 27) is a sectional strip of resilient, more particularly elastomerically deformable, material extending at least along the length of the area where the selectable reference marks (4, 4a) are mounted on the scale (2), preferably over the entire length of the scale, and having a foot part which engages an edge with a force fit in a retaining groove inside the tubular casing (1) and bears the permanent magnets (18, 27) associated with the individual reference marks (4, 4a) at a distance from the foot part outside the activation region for the selector switch (14, 24), and in the region of each reference mark (4, 4a) a closable opening in the casing is provided, through which the strip is bendable around the foot part in this region by inserted screws or pressure members (19, 21), so that the associated permanent magnet (18, 27) is moved into the region for actuating the selector switch (14, 24).

7. A length-measuring system according to any of claims 1 to 6, characterised in that the adjusting drives and/or holders (26) for the permanent magnets (27), in their position holding the permanent magnet in the activation position, simultaneously secure, more particularly clamp, the scale member (2) in the region of the selected reference mark (4, 4a), the scale member being held in the protective casing (1) in a groove (22) for compensating differences in thermal expansion between the casing (1), the scale (2) and the object equipped with the length-measuring system so as to be longitudinally adjustable to the desired extent via flexible mountings (23).

8. A length-measuring system according to claim 7, characterised in that the casing (1) constituting a holder is adapted to be immovably secured to the object in the longitudinal direction by retaining elements (29) in the region of the selected reference mark (4, 4a).

9. A length-measuring system according to claim 8, characterised in that in addition to the immovable mounting (26, 29), mountings (34) flexible in the longitudinal direction in the region of the selected reference mark (4, 4a) are provided for the casing (1) and are in the form of retaining elements (34) attached at a distance from the longitudinal ends of the casing, and having foot parts (36) which extend through slots (33) in the casing and are longitudinally movable in longitudinal grooves (25) or bores in the casing for securing the magnet-holders in the central region of the casing.

## Revendications

1. Système incrémentiel de mesure de longueurs, avec une règle graduée (2) présentant une graduation (3) de mesure, une unité (5) d'exploration avec des éléments d'exploration destinés à produire des signaux de mesure lors de l'exploration de la graduation (3) de mesure et une unité d'exploitation pour ces signaux de mesure, une piste de référence, parallèle à la graduation (3) de mesure, avec plusieurs éléments d'exploration associés chacun à un point de référence ayant des marques de référence (4, 4a) correspondantes, dans l'unité d'exploration (5) et un interrupteur de sélection (14, 24) réglable, à l'aide de l'unité d'exploration (5) pouvant être actionnée par un aimant permanent (13, 18, 27) susceptible d'être monté en association par rapport aux marques de référence (4, 4a) dans un boîtier de protection (1), pour la règle graduée (2) et l'unité d'exploration (5), interrupteur permettant de produire ou d'envoyer une impulsion de référence, seulement en au moins l'une des marques de référence (4, 4a) sélectionnées par l'intermédiaire des aimants permanents (13, 18, 27),
caractérisé en ce qu'un aimant permanent (13, 18, 27) est associé rigidement dans le boîtier de protection (1) à chaque marque de référence (4, 4a) pouvant être sélectionnée et est susceptible d'être réglé pour passer d'une position inactive ou une position active par rapport à l'interrupteur de sélection (14, 24), par l'intermédiaire de mécanisme de réglage.

2. Système de mesure de longueur selon la revendication 1,
caractérisé en ce que chaque aimant permanent (13, 18, 27) est monté réglable, avec un support (12, 17, 26) monté tournant ou pivotant dans le boîtier de protection (1), depuis une position écartée de la trajectoire de déplacement de l'interrupteur de sélection (14, 24) en une position activant l'interrupteur de sélection lors du passage à son niveau.

3. Système de mesure de longueur selon les revendications 1 et 2,
caractérisé en ce que l'interrupteur de sélection (14, 24) est monté dans un organe d'entraînement (19) extérieur destiné à l'unité d'exploration (5) et les aimants permanents (13) avec leurs supports (12, 12a) sont montés dans un perçage de réception ou une rainure de réception prévue à côté de cet organe d'entraînement dans le boîtier de protection (1), dans la direction longitudinale, et peuvent être réglés depuis l'extérieur du boîtier.

4. Système de mesure de longueur selon la revendication 1 et 2,
caractérisé en ce que, dans le cas d'un interrupteur de sélection (14, 24) monté sur l'unité d'exploration (5) à l'intérieur d'une ouverture tubulaire du boîtier de protection (1), les aimants permanents (18, 27) sont logés dans le boîtier de protection (1), sur des supports (17, 26) réglables par l'intermédiaire de mécanismes de réglage extérieurs.

5. Système de mesure de longueur selon la revendication 4,
caractérisé en ce que les aimants permanents (18) reposent sur des clapets (17) montés pivotants à l'aide de parties pieds (15), dans des rainures longitudinales (16) du boîtier de protection (1), pouvant être pivotés à travers des ouvertures de boîtiers pouvant être obturées et pouvant être bloquées dans les positions de pivotement finales.

6. Système de mesure de longueur selon la revendication 4,
caractérisé en ce qu'est prévu comme support pour les aimants permanents (18, 27) une bande profilée en matériau déformable élastique, en particulier ayant l'élasticité du caoutchouc, passant au moins sur la longueur de la zone de placement des marques de référence (4, 4a) pouvant être sélectionnées, sur la règle graduée (2) mais de préférence sur la totalité de la règle graduée (2), la bande s'engageant par une partie pied sur un bord, avec un ajustement serré, dans une rainure de maintien située à l'intérieur du boîtier de protection (1) tubulaire et portant les aimants permanents (18, 27) associés aux marques de référence (4, 4a) individuelles à distance de la partie pied, à l'extérieur de la zone d'activation pour l'interrupteur de sélection, une ouverture de boîtier pouvant être obturée étant prévue dans la zone de chaque marque de référence (4, 40a) ouverture sur laquelle la bande peut être repliée autour de la partie pied, dans cette zone, au moyen de vis ou de corps d'enfoncement (19, 21) ayant été insérés, de manière que l'élément permanent (18, 27) associé se déplace dans la plage d'activation de l'interrupteur de sélection (14, 24).

7. Système de mesure de longueur selon l'une des revendications 1 à 6,
caractérisé en ce que les mécanismes de réglage et/ou le support (26) pour les aimants (27) assurent en même temps la fixation, en particulier le blocage par serrage, dans leur position maintenant l'aimant permanent dans la position d'activation, dans la zone des marques de référence (4, 4a) sélectionnées, du corps de règle graduée (2) maintenu réglable longitudinalement avec le déplacement nécessaire par l'intermédiaire de fixations (23) déformable dans le boîtier de protection (1), dans une rainure (22) pour opérer la compensation des différences de dialtation du boîtier de protection (1), de la règle graduée (2à), respectivement de l'objet équipé du système de mesure de longueur.

8. Système de mesure de longueur selon la revendication 7,
caractérisé en ce que le boîtier de protection (1) formant un support peut être fixé dans la zone des marques de référence (4, 4a) sélectionnées à l'aide d'éléments de maintien (29), de façon immobile dans la direction longitudinale sur l'objet.

9. Système de mesure de longueur selon la revendication ,
caractérisé en ce qu'en plus de la fixation (26, 27) indéplaçable sont prévues, dans la zone des marques de référence (4, 4a) sélectionnées, des fixations (34) déformables en direction longitudinale pour le boîtier de protection (1) et se présentant sous la forme d'éléments des fixations (34) montés à distance des extrémités longitudinales de ce boîtier de protection et s'engageant par des parties pieds (36) dans des fentes de boîtier (33), dans les rainures longitudinales de boîtier (25) ou les perçages de boîtier, pour servir à la fixation du support d'aimant dans la zone centrale du boîtier.
